(19) Europäisches Patentamt
European Patent Office
Office européen des brevets

(11) EP 4 257 621 A1

(12) EUROPEAN PATENT APPLICATION
published in accordance with Art. 153(4) EPC

(43) Date of publication:
**11.10.2023 Bulletin 2023/41**

(21) Application number: **21900373.8**

(22) Date of filing: **10.11.2021**

(51) International Patent Classification (IPC):
***C08F 290/06*** *(2006.01)* ***C08G 73/10*** *(2006.01)*
***G03F 7/004*** *(2006.01)* ***G03F 7/027*** *(2006.01)*
***G03F 7/20*** *(2006.01)*

(52) Cooperative Patent Classification (CPC):
**C08F 290/06; C08G 73/10; G03F 7/004; G03F 7/027; G03F 7/20**

(86) International application number:
**PCT/JP2021/041278**

(87) International publication number:
**WO 2022/118618 (09.06.2022 Gazette 2022/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.12.2020 JP 2020200265**

(71) Applicant: **MITSUBISHI GAS CHEMICAL COMPANY, INC.**
**Chiyoda-ku**
**Tokyo 100-8324 (JP)**

(72) Inventors:
- **MIYAHARA, Daichi**
  **Kurashiki-shi, Okayama 712-8525 (JP)**
- **SATO, Yumi**
  **Kurashiki-shi, Okayama 712-8525 (JP)**
- **UMEKI, Miho**
  **Tokyo 125-8601 (JP)**

(74) Representative: **Müller-Boré & Partner Patentanwälte PartG mbB**
**Friedenheimer Brücke 21**
**80639 München (DE)**

(54) **METHOD FOR PRODUCING PATTERNED SUBSTRATE**

(57) A method for producing a patterned substrate, including: step (a) of forming a film composed of a photosensitive polyimide resin composition on a substrate; step (b) of exposing the film; and step (c) of developing the exposed film using a developer to form a pattern formed of the film on the substrate, wherein a relative energy difference (RED) between the developer and the film before exposure is 0.50 or greater and 1.4 or less.

EP 4 257 621 A1

## Description

Technical Field

The present invention relates to a method for producing a patterned substrate.

Background Art

Photosensitive polyimide resin compositions having excellent heat resistance and insulating properties are used in surface protective films and interlayer insulating films of semiconductor elements of electronic devices, wiring protective insulating films of circuit boards, and the like.

Examples of techniques relating to pattern formation using a photosensitive polyimide resin composition include those described in Patent Documents 1 to 5.

Patent Documents 1 to 4 each describe a developer for a photosensitive polyimide in which water is blended with an organic solvent. Patent Document 5 describes that a developer containing an organic solvent having a ClogP from -1 to 5 is used as a developer for a photosensitive polyimide resin composition.

Citation List

Patent Document

Patent Document 1: JP 2008-292799 A
Patent Document 2: JP 2002-214801 A
Patent Document 3: JP 10-123725 A
Patent Document 4: JP 2002-014476 A
Patent Document 5: WO 2018/221457

Summary of Invention

Technical Problem

When an organic solvent having a high power of dissolving an unexposed portion is used as a developer, in order to improve developability, in pattern formation using a negative type photosensitive polyimide resin composition, an exposed portion is also eroded, which causes cracking in the exposed portion in some cases.

The present invention has been made in view of the above circumstances, and provides a method for producing a patterned substrate, which is capable of suppressing occurrence of cracking in the exposed portion while suppressing generation of a residue in the unexposed portion after development.

Solution to Problem

The present inventors have diligently studied to solve the above problems. As a result, the present inventors have found that the use of a developer having a relative energy difference (RED) from a film composed of a photosensitive polyimide resin composition within a specific range can suppress generation of a residue in the unexposed portion and occurrence of cracking in the exposed portion after development, and can improve developability, and thus have completed the present invention.

That is, the present invention provides the following methods for producing a patterned substrate:

[1] A method for producing a patterned substrate, including:

step (a) of forming a film composed of a photosensitive polyimide resin composition on a substrate;
step (b) of exposing the film; and
step (c) of developing the exposed film using a developer to form a pattern formed of the film on the substrate,
wherein a relative energy difference (RED) between the developer and the film before exposure is 0.50 or greater and 1.4 or less.

[2] The method for producing a patterned substrate according to [1], wherein the step (c) includes step (c1) of

measuring a Hansen solubility parameter of the film before exposure, and step (c2) of selecting a developer having a relative energy difference (RED) from the film before exposure of 0.50 or greater and 1.4 or less using the measured Hansen solubility parameter.

[3] The method for producing a patterned substrate according to [1] or [2], wherein the step (a) includes step (a1) of applying a varnish-state photosensitive polyimide resin composition onto the substrate, and step (a2) of removing an organic solvent from the applied varnish-state photosensitive polyimide resin composition.

[4] The method for producing a patterned substrate according to any one of [1] to [3], further including step (d) of heat-treating the pattern after the step (c).

[5] The method for producing a patterned substrate according to [4], wherein a thickness of the pattern after the heat treatment is 5 μm or greater and 85 μm or less.

[6] The method for producing a patterned substrate according to any one of [1] to [5], wherein a polyimide resin contained in the photosensitive polyimide resin composition includes a modified polyimide resin (A) having a repeating structure represented by General Formula (1):

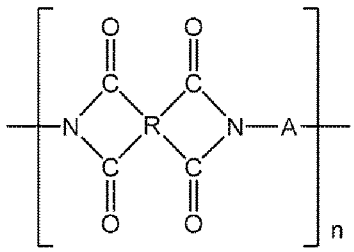

(1)

where R is a tetravalent group with from 4 to 25 carbons, having a cyclic structure, an acyclic structure, or a cyclic structure and an acyclic structure; A has at least one group selected from the group consisting of an aliphatic hydrocarbon group, an alicyclic hydrocarbon group, an aromatic hydrocarbon group, and an organosiloxane group, and is a divalent group with from 2 to 39 carbons; on a main chain of A, at least one intervening group selected from the group consisting of -O-, $-SO_2-$, -CO-, $-CH_2-$, $-C(CH_3)_2-$, $-C_2H_4O-$, and -S- may be present; n represents a number of repeating units; and terminal ends of General Formula (1) are each selected from the group consisting of a group represented by General Formula (2), a group represented by General Formula (3), or a hydrogen atom, and at least one of the terminal ends is a group represented by General Formula (2) or (3); and

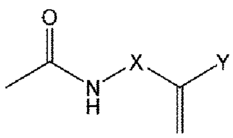

(2)

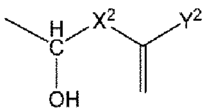

(3)

where X and $X^2$ are each independently a group with from 2 to 15 carbons and may have at least one group selected from the group consisting of ester bonds and double bonds, and Y and $Y^2$ are each independently a hydrogen atom or a methyl group.

[7] The method for producing a patterned substrate according to [6], wherein A in General Formula (1) includes at least one selected from the group consisting of an alicyclic hydrocarbon group and an aromatic hydrocarbon group.

[8] The method for producing a patterned substrate according to any one of [1] to [7], wherein the polyimide resin contained in the photosensitive polyimide resin composition has a weight average molecular weight of 5000 or greater and 70000 or less.

[9] The method for producing a patterned substrate according to any one of [1] to [8], wherein a light transmittance at a wavelength of from 200 to 400 nm of the polyimide resin contained in the photosensitive polyimide resin composition is 50% or greater.

[10] The method for producing a patterned substrate according to any one of [1] to [9], wherein the photosensitive

polyimide resin composition further contains at least one selected from the group consisting of a photopolymerization initiator, an organic solvent, and a photopolymerizable compound.

[11] The method for producing a patterned substrate according to [10], wherein the photopolymerizable compound contains a polyfunctional radically polymerizable monomer.

[12] The method for producing a patterned substrate according to [10] or [11], wherein the photopolymerizable compound includes a polyfunctional (meth)acrylate having four or more (meth)acryloyl groups in a molecule thereof.

[13] The method for producing a patterned substrate according to any one of [1] to [12], wherein the photosensitive polyimide resin composition further contains at least one selected from the group consisting of a sensitizer, a leveling agent, and an adhesion improver.

Advantageous Effects of Invention

The present invention can provide a patterned substrate in which generation of a residue in an unexposed portion and occurrence of cracking in an exposed portion are suppressed.

Description of Embodiments

Hereinafter, embodiments for carrying out the present invention (hereinafter, referred to simply as "the present embodiment") will be described in detail. The following embodiments are examples for explaining the present invention, and do not limit the contents of the present invention. The present invention can be modified as appropriate within the scope of the gist. In the present embodiment, the preferred stipulations can be optionally employed, and combinations of the preferred ones are considered more preferable. In the present embodiment, the phrase "from XX to YY" means "XX or greater and YY or less".

The term "(meth)acrylate" means both "acrylate" and "methacrylate". The same applies to other similar terms ("(meth)acrylic acid", "(meth)acryloyl group", etc.).

The method for producing a patterned substrate according to the present embodiment includes the following steps (a), (b) and (c):

step (a) of forming a film composed of a photosensitive polyimide resin composition on a substrate;
step (b) of exposing the film; and
step (c) of developing the exposed film using a developer to form a pattern formed of the film on the substrate.

A relative energy difference (RED) between the developer and the film before exposure is 0.50 or greater, preferably 0.52 or greater, more preferably 0.55 or greater, and further preferably 0.60 or greater, from the perspective of suppressing occurrence of cracking in the exposed portion after development, and 1.4 or less, preferably 1.3 or less, more preferably 1.2 or less, and further preferably 1.1 or less, from the perspective of suppressing generation of a residue in the unexposed portion after development.

Here, the relative energy difference (RED) can be calculated according to Equation (1).

$$\mathrm{RED} = R_a/R_0 \quad (1)$$

where $R_a$ is a distance between a Hansen solubility parameter (hereinafter also referred to as "HSP") of a solute (i.e., the film before exposure in the present embodiment) and an HSP of a solvent (i.e., the developer in the present embodiment), i.e., an HSP distance, and $R_0$ is an interaction radius of the solute.

$R_a$ (HSP distance) can be calculated according to Equation (2).

$$R_a = \{4(\delta dS - \delta dL)^2 + (\delta pS - \delta pL)^2 + (\delta hS - \delta hL)^2\}^{0.5} \quad (2)$$

where δdS is an energy due to London dispersion force of the solute, δpS is an energy due to a dipole interaction of the solute, 6hS is an energy due to a hydrogen bond of the solute, δdL is an energy due to a London dispersion force of the solvent, δpL is an energy due to a dipole interaction of the solvent, and δhL is an energy due to a hydrogen bond of the solvent.

$R_0$ (interaction radius of the solute) is determined by, for example, the Hansen sphere method. First, a solute whose $R_0$ is to be determined and several solvents whose HSPs are known are prepared, and a test on solubility of the target solute in each of the solvents is performed. In the solubility test, the HSP of the solvent in which the solute exhibited solubility and the HSP of the solvent in which the solute did not exhibit solubility are plotted on a Hansen space. Based

on the plotted HSPs of the respective solvents, a virtual sphere (Hansen sphere) is created on the Hansen space so as to include the HSPs of the solvents in which the solute exhibited solubility and not to include the HSPs of the solvents in which the solute did not exhibit solubility. The radius of the Hansen sphere is defined as $R_0$.

The HSP is an index of the solubility indicating a degree of dissolution of a substance in another substance. The HSP is a vector quantity represented as, for example, (δd, δp, δh), which is composed of three parameters: an energy due to a London dispersion force (δd), an energy due to a dipole interaction (δp), and an energy due to a hydrogen bond (δh), and is represented by being plotted on a three dimensional space (Hansen space) having the three parameters of the HSP as coordinate axes. When substances are similar in vector, it can be determined that the one substance has high solubility in the other substance. The unit of each parameter is usually expressed as $MPa^{1/2}$. As for HSP, for example, see the Internet <URL:http://hansen-solubility. com/>. As a method for measuring the HSP of a target polymer material, a method using the Hansen sphere method installed in HSPiP (Hansen Solubility Parameters in Practice) which is commercially available software is known. In this method, the solubility of a target material in a plurality of solvents whose HSPs are known is confirmed through a dissolution experiment. In the present embodiment, the version of the software used is (version 5.3.02).

Hereinafter, each step of the method for producing a patterned substrate according to the present embodiment will be described.

[Step (a)]

First, a film composed of a photosensitive polyimide resin composition is formed on a substrate.

Step (a) preferably includes, for example, step (a1) of applying a varnish-state photosensitive polyimide resin composition (hereinafter also simply referred to as "polyimide varnish") onto the substrate, and step (a2) of removing an organic solvent from the applied photosensitive polyimide resin composition.

The method of applying the polyimide varnish on the substrate is not particularly limited, and examples thereof can include inkjet methods, spin coating methods, casting methods, microgravure methods, gravure coating methods, bar coating methods, roll coating methods, wire bar coating methods, dip coating methods, spray coating methods, screen printing methods, flexographic printing methods, and die coating methods.

When the polyimide varnish is applied onto the substrate, the solid content concentration thereof is preferably adjusted to fall within a range of from 5 to 50 mass%.

The polyimide varnish applied onto the substrate is dried to remove the organic solvent from the applied polyimide varnish.

The polyimide varnish is dried by heat treatment using, for example, a hot plate, hot air, an oven, or the like. A heating temperature is, for example, from 80 to 140°C, and preferably from 90 to 120°C. A heating time is, for example, about from 30 to 600 seconds, preferably about from 30 to 300 seconds.

A thickness of the film composed of the photosensitive polyimide resin composition is not particularly limited and may be appropriately adjusted depending on the pattern to be finally produced. The thickness of the film is, for example, 5 μm or greater and 85 μm or less. The thickness of the film can be adjusted by changing the content of the organic solvent in the polyimide varnish, the application method, the application conditions, and the like.

Examples of the substrate include glass, silicon wafer, metal foil, and plastic film. Among the substrates above, a silicon wafer and copper foil are suitably used.

<Photosensitive Polyimide Resin Composition>

The photosensitive polyimide resin composition according to the present embodiment contains polyimide resin, preferably further contains at least one selected from the group consisting of a photopolymerization initiator, an organic solvent, and a photopolymerizable compound. The photosensitive polyimide resin composition may further contain at least one selected from the group consisting of a sensitizer, a leveling agent, and an adhesion improver.

A content of the polyimide resin in the photosensitive polyimide resin composition according to the present embodiment is preferably 30 mass% or greater, more preferably 40 mass% or greater, further preferably 50 mass% or greater, and even further preferably 60 mass% or greater, and preferably 90 mass% or less, more preferably 80 mass% or less, and further preferably 70 mass% or less based on 100 mass% of a total solid content of the photosensitive polyimide resin composition.

Here, in the present embodiment, the total solid content of the photosensitive polyimide resin composition is a component remaining as a solid content when the photosensitive polyimide resin composition is cured, and for example, a component volatilized by heating such as an organic solvent is excluded. On the other hand, even in the case of the liquid component, the component incorporated into the resin film when heated and cured is included in the total solid content.

(Polyimide Resin)

Examples of the polyimide resin according to the present embodiment can include a polyimide resin including a structural unit A derived from a tetracarboxylic dianhydride and a structural unit B derived from a diamine compound.

The tetracarboxylic acid contained in the structural unit A can be any tetracarboxylic acid, and examples thereof include cyclohexanetetracarboxylic acid, cyclohexanetetracarboxylic esters, cyclohexanetetracarboxylic dianhydride, cyclobutanetetracarboxylic acid, cyclobutanetetracarboxylic esters, cyclobutanetetracarboxylic dianhydride, cyclopentanetetracarboxylic acid, cyclopentanetetracarboxylic esters, cyclopentanetetracarboxylic dianhydrides, and bicyclopentanetetracarboxylic dianhydrides. Of these, the tetracarboxylic acid is more preferably cyclohexanetetracarboxylic dianhydride, cyclobutanetetracarboxylic dianhydride, and cyclopentanetetracarboxylic dianhydride, and further preferably cyclohexanetetracarboxylic dianhydride. The various tetracarboxylic acid components described above include a positional isomer.

More preferred specific examples of the tetracarboxylic acid component described above include 1,2,4,5-cyclohexanetetracarboxylic acid, 1,2,4,5-cyclohexanetetracarboxylic dianhydride, 1,2,4,5-cyclohexanetetracarboxylic acid methyl ester, 1,2,3 4-butanetetracarboxylic acid, 1,2,3,4-butanetetracarboxylic dianhydride, 1,2,3,4-butanetetracarboxylic acid methyl ester, 1,2,3,4-cyclobutanetetracarboxylic acid, 1,2,3,4-cyclobutanetetracarboxylic dianhydride, 1,2,3 4-cyclobutanetetracarboxylic acid methyl ester, 1,2,4,5-cyclopentanetetracarboxylic acid, 1,2,4,5-cyclopentanetetracarboxylic dianhydride, 1,2,4,5-cyclopentanetetracarboxylic acid methyl ester, 3-carboxymethyl-1,2,4-cyclopentanetricarboxylic acid, bicyclo[2.2.2]octa-7-ene-2,3,5,6-tetracarboxylic acid, bicyclo[2.2.2]octa-7-ene-2,3,5,6-tetracarboxylic dianhydride, bicyclo[2.2.2]octa-7-ene-2,3,5,6-tetracarboxylic acid methyl ester, dicyclohexyltetracarboxylic acid, dicyclohexyltetracarboxylic dianhydride, and dicyclohexyltetracarboxylic acid methyl ester.

Among these, 1,2,4,5-cyclohexanetetracarboxylic acid, 1,2,4,5-cyclohexanetetracarboxylic dianhydride, 1,2,3,4-cyclobutanetetracarboxylic dianhydride, and 1,2,4,5-cyclohexanetetracarboxylic acid methyl ester are particularly preferable because they facilitate increase in the molecular weight in production of the polyimide resin and they are advantageous in production of a flexible film.

The structural unit B is derived from a diamine compound, and examples thereof can include at least one selected from the group consisting of compounds represented by the following formulas.

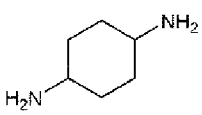 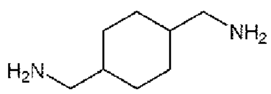 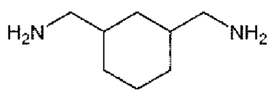

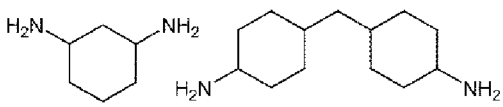 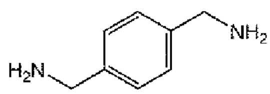

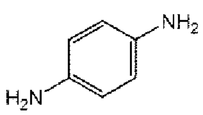 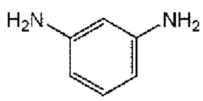 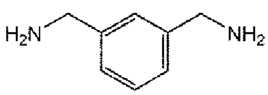

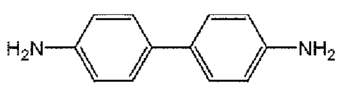 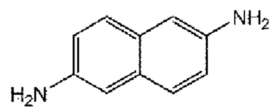

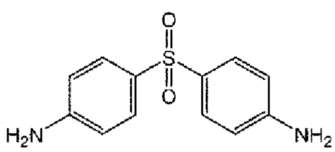 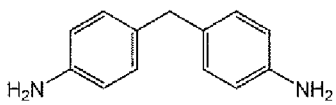

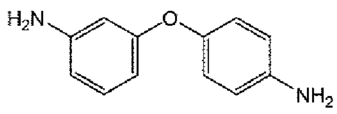

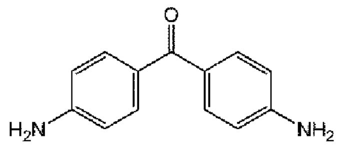

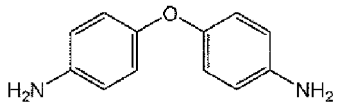

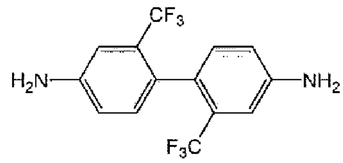

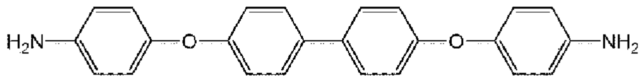

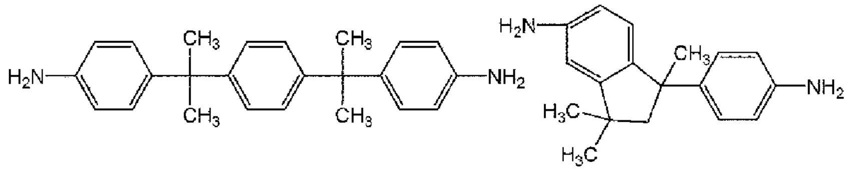

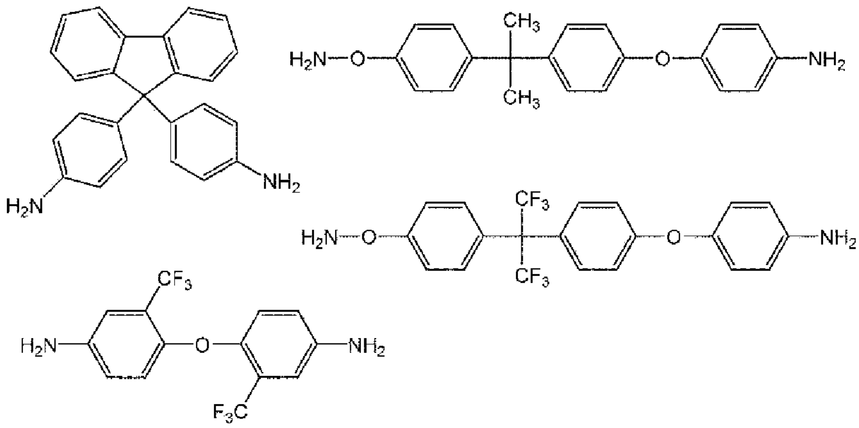

Among the above, it is preferable that the structural unit B should include a structural unit B1 derived from at least one selected from the group consisting of compounds represented by the following formulas.

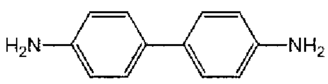

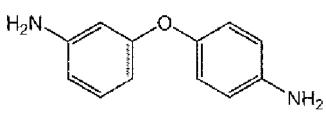

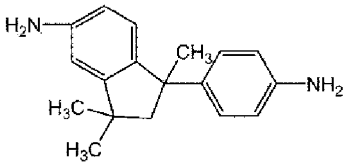

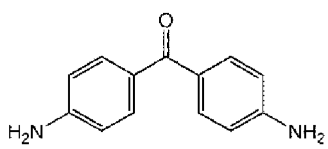

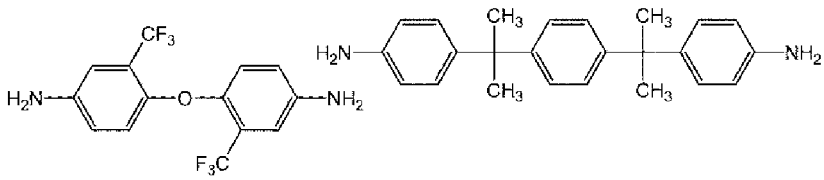

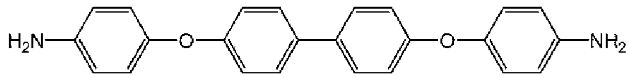

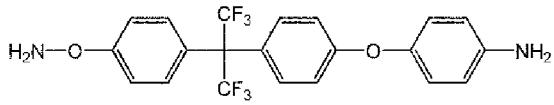

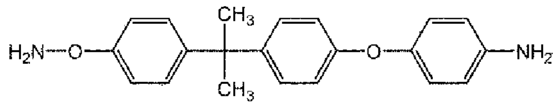

It is further preferable that the structural unit B should include a structural unit B2 derived from at least one selected from the group consisting of compounds represented by the following formulas.

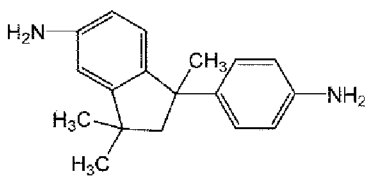

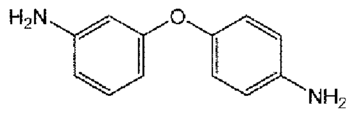

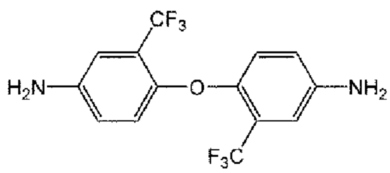

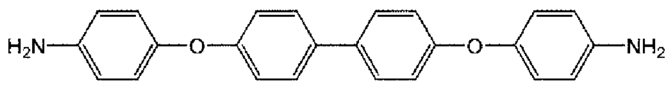

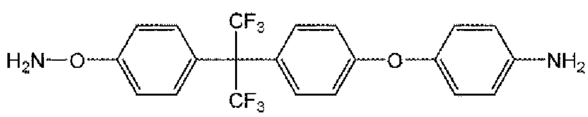

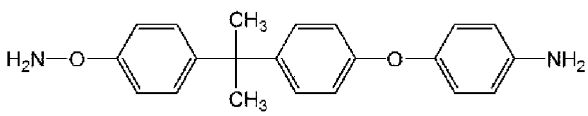

In particular, it is preferable that the structural unit B2 should include a structural unit derived from a compound represented by Formula (4), since the produced polyimide resin is more excellent in solubility in the organic solvent.

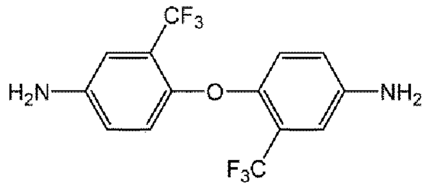

(4)

The polyimide resin according to the present embodiment preferably includes the structural unit B 1 or the structural unit B2 in a proportion of 60 mol% or greater as the structural unit B derived from a diamine. When the proportion of the structural unit B 1 or the structural unit B2 in the structural unit B is 60 mol% or greater, a polyimide resin having excellent solubility in the organic solvent can be produced.

A proportion of the structural unit B 1 or the structural unit B2 in the structural unit B is more preferably 70 mol% or greater, further preferably 80 mol% or greater, even further preferably 95 mol% or greater, and particularly preferably 100 mol%. Especially, it is preferable that the structural unit B2 should be included as the structural unit B, and that the structural unit B2 should include the structural unit derived from the diamine represented by Formula (4) in the above proportion.

A weight average molecular weight of the polyimide resin is preferably 70000 or less. When the weight average molecular weight is 70000 or less, the polyimide resin has more excellent solubility in the organic solvent, and thus is suitable for forming a cured film. The weight average molecular weight is preferably 60000 or less, more preferably 50000 or less, further preferably 45000 or less, and even further preferably 40000 or less. Since a cured film having desired mechanical properties can be produced, the weight average molecular weight of the polyimide resin is preferably 5000 or greater. The weight average molecular weight of the polyimide resin is more preferably 10000 or greater, further preferably 13000 or greater, and even further preferably 15000 or greater. When the weight average molecular weight of the polyimide resin is within the above range, for example, in a case where the polyimide resin is used to produce a photosensitive polyimide resin composition, a resin composition which has solubility in the organic solvent and also has a low residual film rate of the unexposed portion and excellent developability can be produced. Here, the weight average molecular weight is a weight average molecular weight in terms of polystyrene.

(Method for Producing Polyimide Resin)

The polyimide resin according to the present embodiment includes a structural unit A derived from a tetracarboxylic dianhydride and a structural unit B derived from a diamine compound, and the tetracarboxylic dianhydride and the diamine compound as raw materials are as described above. The polyimide resin according to the present embodiment can be formed by reacting the tetracarboxylic acid and the diamine component with each other. The polyimide resin according to the present embodiment has an amino group at a terminal end.

The organic solvent used when the tetracarboxylic acid component and the diamine component are reacted is not particularly limited, but is preferably an organic solvent containing at least one selected from the group consisting of cyclic ethers, cyclic ketones, cyclic esters, amides and ureas. Specific examples of suitable solvents can include, but are not limited to, at least one type selected from the group consisting of aprotic polar organic solvents such as γ-butyrolactone, N,N-dimethylacetamide, N,N-dimethylformamide, N-methyl-2-pyrrolidone, dimethyl sulfoxide, hexamethylphosphoramide, cyclopentanone, cyclohexanone, 1,3-dioxolane, 1,4-dioxane, tetramethylurea and tetrahydrofuran. Among these, the solvent is preferably one or more selected from the group consisting of γ-butyrolactone, N,N-dimethylacetamide, N,N-dimethylformamide, and N-methyl-2-pyrrolidone.

When the tetracarboxylic acid component and the diamine component are reacted, an imidization catalyst can be used. As the imidization catalyst, a tertiary amine compound is preferable, and specifically, at least one selected from the group consisting of trimethylamine, triethylamine (TEA), tripropylamine, tributylamine, triethanolamine, N,N-dimethylethanolamine, N,N-diethylethanolamine, triethylenediamine, N-methylpyrrolidine, N-ethylpyrrolidine, N-methylpiperidine, N-ethylpiperidine, imidazole, pyridine, quinoline and isoquinoline can be used.

A reaction temperature is, for example, in the range from 160 to 200°C, preferably in the range from 170 to 190°C, and more preferably in the range from 180 to 190°C. If the reaction temperature is the lower limit value or higher, imidization and polymerization can be sufficiently advanced. If the reaction temperature is the upper limit value or lower, the solution viscosity can be appropriately maintained, and problems such as charring of the resin on the wall of the reaction vessel can be avoided. In some cases, azeotropic dehydrating agents such as toluene and xylene may be used. The reaction pressure is usually normal pressure, but if necessary, the reaction can be carried out under pressure. The retention time of the reaction temperature is preferably at least 1 hour or longer, and more preferably 3 hours or longer. If the reaction retention time is 1 hour or longer, imidization and polymerization can be sufficiently advanced. The upper limit of the reaction time is not particularly limited, and the reaction is performed in a range of from 3 to 10 hours.

In production of the polyimide resin according to the present embodiment, "A mol" of the tetracarboxylic acid component and "B mol" of the diamine component are reacted preferably in a range of $0.80 \leq A/B \leq 0.99$, and more preferably in a range of $0.85 \leq A/B \leq 0.95$. When $A/B \leq 0.99$, the terminal end of the polyimide can be made into a diamine in excess, a polyimide resin having an amino group at a terminal end can be produced, and a polyimide resin having a molecular weight which satisfies sufficient solubility in the organic solvent can be produced. When $0.80 \leq A/B$, a polyimide resin having a molecular weight that realizes sufficient flexibility can be produced.
As the ratio A/B approaches 1.0, a polyimide resin having a high molecular weight can be formed. Therefore, when the ratio A/B is adjusted appropriately, a polyimide resin having a target molecular weight can be produced.

(Modified Polyimide Resin (A))

The polyimide resin according to the present embodiment preferably includes a modified polyimide resin having a repeating structure represented by General Formula (1).

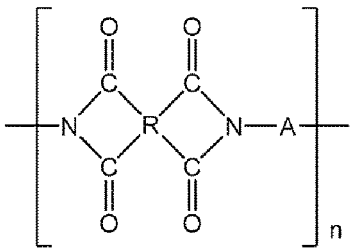
(1)

where R is a tetravalent group with from 4 to 25 carbons, preferably from 4 to 10 carbons, having a cyclic structure, an acyclic structure, or a cyclic structure and an acyclic structure; A has at least one group selected from the group consisting of an aliphatic hydrocarbon group, an alicyclic hydrocarbon group, an aromatic hydrocarbon group, and an organosiloxane group, and is a divalent group with from 2 to 39 carbons; on a main chain of A, at least one intervening group selected from the group consisting of -O-, $-SO_2-$, -CO-, $-CH_2-$, $-C(CH_3)_2-$, - $C_2H_4O-$, and -S- may be present; n represents a number of repeating units; and Terminal ends of General Formula (1) is either a group represented by General Formula (2) or (3), or a hydrogen atom, and at least one of the terminal ends is a group represented by General Formula (2) or (3).

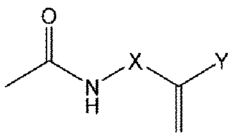
(2)

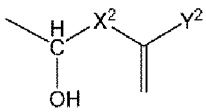
(3)

where X and $X^2$ are each independently a group with from 2 to 15 carbons and may have at least one group selected from the group consisting of ester bonds and double bonds; and Y and $Y^2$ are each independently a hydrogen atom or a methyl group.
R in General Formula (1) preferably has at least a cyclic structure, and examples of the cyclic structure include tetravalent groups formed by removal of four hydrogen atoms from cyclohexane, cyclopentane, cyclobutane, bicyclopentane, and these stereoisomers.
In addition, as described above with respect to the polyimide resin, R in General Formula (1) may include a structural unit derived from any tetracarboxylic acid. Preferred examples are as described above, and examples of the structural unit can include the following structures.

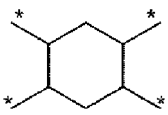 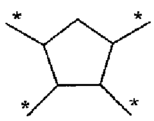 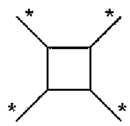 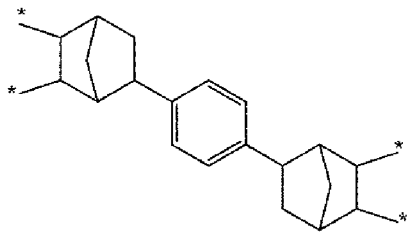

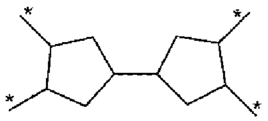 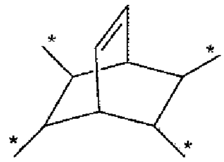

where * indicates an atomic bond.

Of these, a tetravalent group formed by removal of four hydrogen atoms from cyclohexane is more preferable.

In General Formula (1), A is a divalent group with from 2 to 39 carbons, having at least one group selected from the group consisting of an aliphatic hydrocarbon group, an alicyclic hydrocarbon group, an aromatic hydrocarbon group, and an organosiloxane group. On a main chain of A, at least one intervening group selected from the group consisting of -O-, $-SO_2-$, -CO-, $-CH_2-$, $-C(CH_3)_2-$, $-C_2H_4O-$, and -S- may be present.

More specifically, A includes divalent groups formed by removal of two hydrogen atoms from compounds such as cyclohexane, dicyclohexylmethane, dimethylcyclohexane, isophorone, norbornane and alkyl substitutes thereof and halogen substitutes; benzene, naphthalene, biphenyl, diphenylmethane, diphenyl ether, diphenylsulfone, benzophenone and alkyl substitutes and halogen substitutes thereof; and organo(poly)siloxanes. A preferably has a cyclic structure, and also preferably has at least one selected from the group consisting of an alicyclic hydrocarbon group and an aromatic hydrocarbon group. Preferably, A has an aromatic ring as an aromatic hydrocarbon group. More specifically, a divalent group having 6 to 27 carbons represented by the following structural formula is preferable.

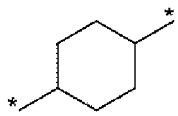 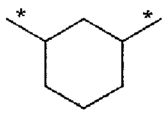 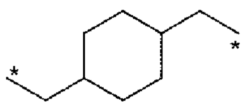 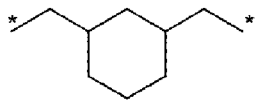

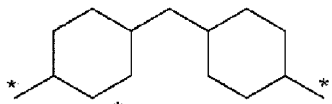 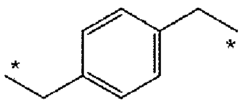 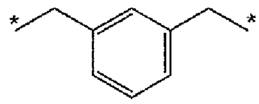

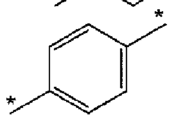 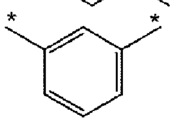 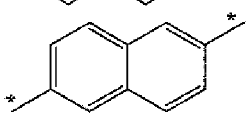 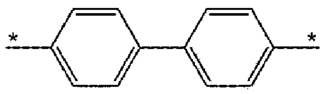

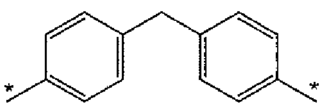 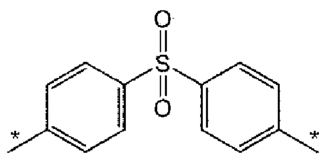 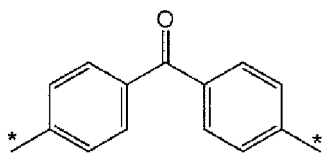

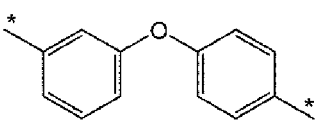 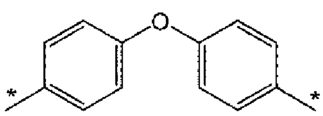 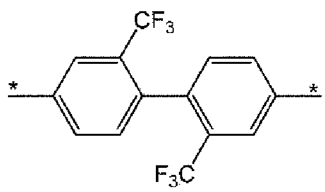

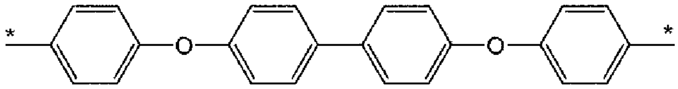

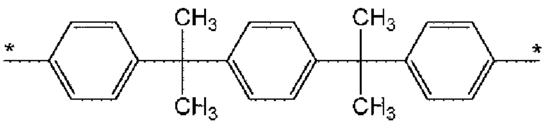
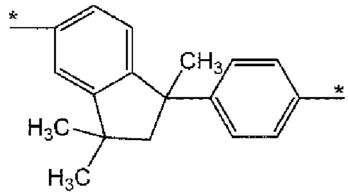

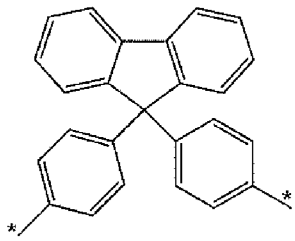
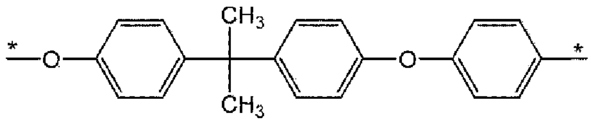
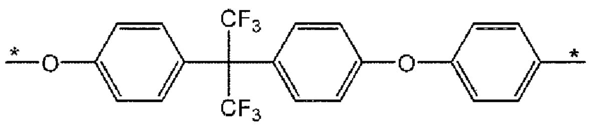

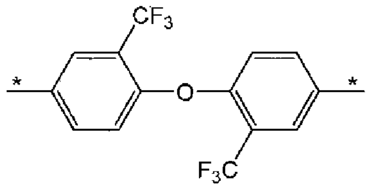

where * indicates an atomic bond.

More specifically, examples of the divalent group with from 2 to 39 carbon atoms represented by A preferably include at least one group (I-a) selected from the group consisting of the following structures.

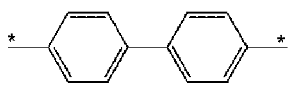
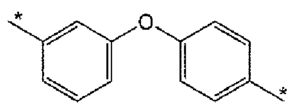

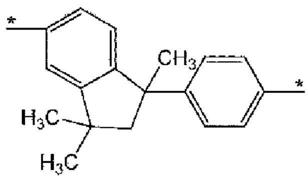
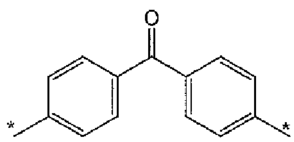

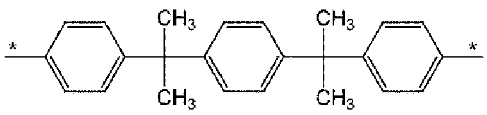
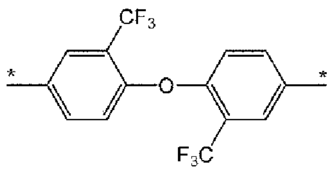

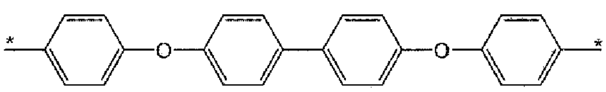

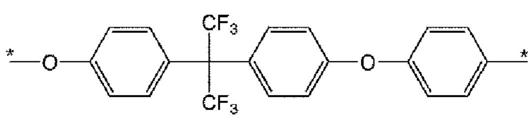

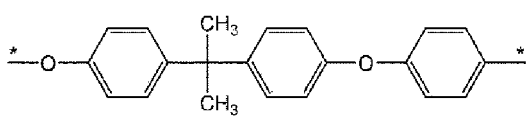

where * indicates an atomic bond.

More preferably, the group corresponding to A exemplified more preferably includes at least one group (I-b) selected from the group consisting of the following structures.

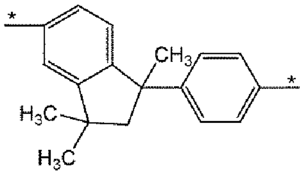

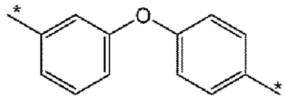

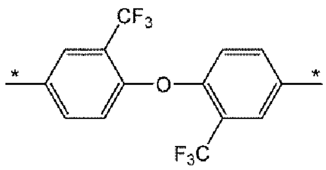

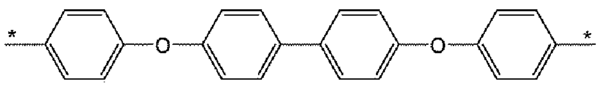

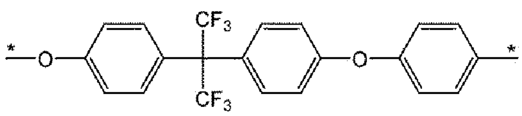

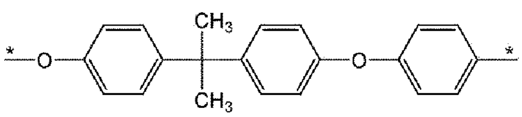

where * indicates an atomic bond.

It is particularly preferable that A in General Formula (1) should have a group represented by the following General Formula (I-c).

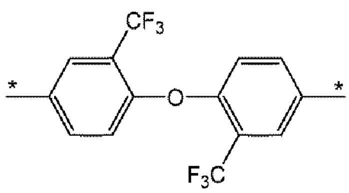

(I-c)

where * indicates an atomic bond.

In the modified polyimide resin (A) according to the present embodiment, a proportion of at least one structural unit selected from the group consisting of (I-a), (I-b), and (I-c) as A in General Formula (1) is preferably 60 mol% or greater from the perspective of solubility in the organic solvent.

The proportion of at least one structural unit selected from the group consisting of (I-a), (I-b), and (I-c) as A in General Formula (1) is more preferably 70 mol% or greater, further preferably 80 mol% or greater, even further preferably 95 mol% or greater, and particularly preferably 100 mol%. Among them, preferably, the structural units derived from the diamine represented by formula (I-c) are included in the above proportion.

n indicating the number of repeating units of the structural unit represented by General Formula (1) is preferably from 5 to 250, more preferably from 10 to 200, and further preferably from 15 to 150. When n is 5 or greater, a cured film having desired mechanical properties can be produced. When n is 250 or less, sufficient solubility in the organic solvent can be secured.

The modified polyimide resin (A) according to the present embodiment has either the group represented by General Formula (2) or (3), or a hydrogen atom at each of the terminal ends, and at least one of the terminal ends is a

group represented by General Formula (2) or (3). The modified polyimide resin (A) may have a structure represented by General Formula (2) or (3) at one terminal end, or may have a structure represented by General Formula (2) or (3) at both terminal ends.

The group represented by X or $X^2$ in General Formula (2) or (3) is a group with from 2 to 15 carbons and may have at least one group selected from the group consisting of ester bonds and double bonds. The group represented by Y or $Y^2$ is a hydrogen atom or a methyl group.

More specifically, the structure represented by General Formula (2) or (3) corresponds to a structure formed by reacting a terminal diamine of the polyimide resin with a functional group-containing compound. Examples of the functional group-containing compound include compounds having an isocyanate group or an epoxy group and a (meth)acryl group. Examples of such compounds include 2-isocyanatoethyl methacrylate, 2-isocyanatoethyl acrylate, 1,1-bis(acryloyloxymethyl)ethyl isocyanate, glycidyl methacrylate, glycidyl acrylate, and allyl glycidyl ether. The structure represented by General Formula (2) or (3) may have a structure formed by reacting the compound and the amine terminal.

A weight average molecular weight of the modified polyimide resin (A) is preferably 70000 or less. When the weight average molecular weight is 70000 or less, the modified polyimide resin (A) has more excellent solubility in the organic solvent, and thus is suitable for forming a cured film. The weight average molecular weight is preferably 60000 or less, more preferably 50000 or less, further preferably 45000 or less, and even further preferably 40000 or less. Since a cured film having desired mechanical properties can be produced, the weight average molecular weight of the modified polyimide resin (A) is preferably 5000 or greater. The weight average molecular weight of the modified polyimide resin (A) is more preferably 10000 or greater, further preferably 13000 or greater, and even further preferably 15000 or greater. When the weight average molecular weight of the modified polyimide resin (A) is within the range described above, a residual film ratio of the unexposed portion is low, and a resin composition having excellent characteristics in development can be formed. Here, the weight average molecular weight is a weight average molecular weight in terms of polystyrene.

The modified polyimide resin (A) can be produced by reacting the diamine component and the tetracarboxylic acid component which will be described in detail below.

Examples of the diamine component can include diamine, diisocyanate and diaminodisilane, and diamine is preferable. The diamine content in the diamine component used as a raw material is preferably 50 mol% or greater and may be 100 mol%.

The diamine may be an aliphatic diamine or an aromatic diamine and may be a mixture thereof. In the present embodiment, the "aromatic diamine" refers to a diamine in which an amino group is directly bonded to an aromatic ring, and may include an aliphatic group, an alicyclic group, or any other substituent in part of the structure. "Aliphatic diamine" refers to a diamine in which an amino group is directly bonded to an aliphatic group or an alicyclic group, and "aliphatic diamine" may include an aromatic group or other substituent groups in part of the structure.

In general, when an aliphatic diamine is used as a raw material of a polyimide resin, a polyamide acid which is an intermediate product and the aliphatic diamine form a strong complex, making it difficult to produce a high-molecular weight polyimide. Therefore, improvements such as the use of an organic solvent in which the complex has a relatively high solubility, such as using cresols or the like, is required. When cyclohexanetetracarboxylic acid, cyclobutanetetracarboxylic acid, or derivative thereof is used as the tetracarboxylic acid component, a complex having a relatively weak bond between the polyamic acid and the aliphatic diamine is formed. Thus, the molecular weight of the polyimide can be easily increased. When a diamine having a fluorine substituent is selected as a raw material, transparency of the produced polyimide resin is excellent, which is preferable.

As the aliphatic diamine, any aliphatic diamine can be used. Examples of the aliphatic diamine include 4,4'-diaminodicyclohexylmethane, ethylenediamine, hexamethylenediamine, polyethyleneglycol bis(3-aminopropyl)ether, polypropyleneglycol bis(3-aminopropyl)ether, 1,3-bis(aminomethyl)cyclohexane, 1,4-bis(aminomethyl)cyclohexane, m-xylylenediamine, p-xylylenediamine, isophorone diamine, norbornane diamine, and siloxane diamines.

Examples of the aromatic diamine include 4,4'-diaminodiphenyl ether, 4,4'-diaminodiphenylmethane, 4,4'-diaminodiphenyl sulfone, m-phenylenediamine, p-phenylenediamine, diaminobenzophenone, 2,6-diaminonaphthalene, 1,5-diaminonaphthalene, 4,4'-diamino-2,2'-bis(trifluoromethyl)biphenyl, 4,4'-oxybis[3-(trifluoromethyl)benzenamine], and 1-(4-aminophenyl)-2,3-dihydro-1,3,3-trimethyl-1H-inden-5-amine.

The diamine preferably contains at least 4,4'-diamino-2,2'-bis(trifluoromethyl)biphenyl, 4,4'-oxybis[3-(trifluoromethyl)benzenamine] or 1-(4-aminophenyl)-2,3-dihydro-1,3,3-trimethyl-1H-inden-5-amine. When any one of the diamines described above is included as the diamine component, the photosensitive resin composition containing the modified polyimide resin (A) produced has high light transmittance at a specific wavelength and high solubility in the organic solvent. Therefore, it has excellent curability of the exposed portion, a low residual film rate of the unexposed portion, and excellent developability. Any one of the diamines described above has only to be contained as the diamine component, and excellent effects are maintained even when the diamine is used in combination with any other diamine. The modified polyimide resin (A) according to the present embodiment preferably includes at least one of units composed of 4,4'-diamino-2,2'-bis(trifluoromethyl)biphenyl, 1-(4-aminophenyl)-2,3-dihydro-1,3,3-trimethyl-1H-inden-5-amine, or 4,4'-oxybis[3-(trifluoromethyl)benzenamine].

As the tetracarboxylic acid component, any tetracarboxylic acid component can be used. Examples of the tetracarboxylic acid component include cyclohexanetetracarboxylic acid, cyclohexanetetracarboxylic esters, cyclohexanetetracarboxylic dianhydride, cyclobutanetetracarboxylic acid, cyclobutanetetracarboxylic esters, cyclobutanetetracarboxylic dianhydride, cyclopentanetetracarboxylic acid, cyclopentanetetracarboxylic esters, cyclopentanetetracarboxylic dianhydrides, and bicyclopentanetetracarboxylic dianhydrides. Of these, cyclohexanetetracarboxylic dianhydride, cyclobutanetetracarboxylic dianhydride, and cyclopentanetetracarboxylic dianhydride are more preferable. Among them, cyclohexanetetracarboxylic dianhydride is more preferable. The various tetracarboxylic acid components described above include a positional isomer.

More preferred specific examples of the tetracarboxylic acid component described above include 1,2,4,5-cyclohexanetetracarboxylic acid, 1,2,4,5-cyclohexanetetracarboxylic dianhydride, 1,2,4,5-cyclohexanetetracarboxylic acid methyl ester, 1,2,3 4-butanetetracarboxylic acid, 1,2,3,4-butanetetracarboxylic dianhydride, 1,2,3,4-butanetetracarboxylic acid methyl ester, 1,2,3,4-cyclobutanetetracarboxylic acid, 1,2,3,4-cyclobutanetetracarboxylic dianhydride, 1,2,3 4-cyclobutanetetracarboxylic acid methyl ester, 1,2,4,5-cyclopentanetetracarboxylic acid, 1,2,4,5-cyclopentanetetracarboxylic dianhydride, 1,2,4,5-cyclopentanetetracarboxylic acid methyl ester, 3-carboxymethyl-1,2,4-cyclopentanetricarboxylic acid, bicyclo[2.2.2]octa-7-ene-2,3,5,6-tetracarboxylic acid, bicyclo[2.2.2]octa-7-ene-2,3,5,6-tetracarboxylic dianhydride, bicyclo[2.2.2]octa-7-ene-2,3,5,6-tetracarboxylic acid methyl ester, dicyclohexyltetracarboxylic acid, dicyclohexyltetracarboxylic dianhydride, and dicyclohexyltetracarboxylic acid methyl ester.

Among these, 1,2,4,5-cyclohexanetetracarboxylic acid, 1,2,4,5-cyclohexanetetracarboxylic dianhydride, 1,2,3,4-cyclobutanetetracarboxylic dianhydride, and 1,2,4,5-cyclohexanetetracarboxylic acid methyl ester are particularly preferable because they facilitate increase in the molecular weight in production of the polyimide resin and they are advantageous in production of a flexible film.

The tetracarboxylic acid component may include other tetracarboxylic acid or a derivative thereof in a range that does not impair the flexibility and thermocompression bonding property of the resulting cured film, for example, the film. Examples of these other tetracarboxylic acids or derivatives thereof can include at least one selected from: pyromellitic acid, 3,3',4,4'-biphenyltetracarboxylic acid, 2,3,3',4'-biphenyltetracarboxylic acid, 2,2-bis(3,4-dicarboxyphenyl)propane, 2,2-bis(2,3-dicarboxyphenyl)propane, 2,2-bis(3,4-dicarboxyphenyl)-1,1,1,3,3,3-hexafluoropropane, 2,2-bis(2,3-dicarboxyphenyl)-1,1,1,3,3,3-hexafluoropropane, bis(3,4-dicarboxyphenyl)sulfone, bis(3,4-dicarboxyphenyl)ether, bis(2,3-dicarboxyphenyl)ether, 3,3',4,4'-benzophenone tetracarboxylic acid, 2,2',3,3'-benzophenone tetracarboxylic acid, 4,4-(p-phenylenedioxy)diphthalic acid, 4,4-(m-phenylenedioxy)diphthalic acid, ethylenetetracarboxylic acid, 1,1-bis(2,3-dicarboxyphenyl)ethane, bis(2,3-dicarboxyphenyl)methane, bis(3,4-dicarboxyphenyl)methane, and derivatives thereof.

(Method for Producing Modified Polyimide Resin (A))

The modified polyimide resin (A) according to the present embodiment can be produced by the following steps (1) and (2).

Step (1): a tetracarboxylic acid component and a diamine component are reacted to produce a polyimide resin having an amino group in its terminal end.

Step (2): the polyimide resin having an amino group at the terminal end produced in step (1) above, the functional group-containing compound (a compound having an isocyanate group or an epoxy group and a (meth)acryl group) are reacted.

In step (1), the tetracarboxylic acid and the diamine component described above are reacted to form a polyimide resin having an amino group at its terminal end.

The above step (1) is the same as the method for producing a polyimide resin described above. Materials used as raw materials, preferable materials and reaction conditions are also the same.

Step (2) is a step of modifying the terminal end of the polyimide resin produced in step (1). Specifically, as described above, the polyimide and the functional group-containing compound described above (a compound having an isocyanate group or epoxy group and a (meth)acryl group) are reacted to produce a modified polyimide resin (A) having a (meth)acryl group at its terminal end.

The functional group-containing compound that modifies the terminal end of the polyimide resin is a compound having an isocyanate group or an epoxy group and a (meth)acryl group. Specific examples include 2-isocyanatoethyl methacrylate, 2-isocyanatoethyl acrylate, 1,1-bis(acryloyloxymethyl)ethyl isocyanate, glycidyl methacrylate, and allyl glycidyl ether. These functional group-containing compounds may be used alone or in combination of two or more. The functional group-containing compound is preferably used at a ratio from 0.1 to 30 molar ratio with respect to a polyimide resin having an amino group at a terminal end.

A reaction temperature in step (2) is preferably in a range of from 30 to 100°C, and a reaction time is preferably

from 1 to 10 hours.

When the amino group terminal of the polyimide resin is reacted with the isocyanate group or epoxy group of the functional-group-containing compound, they may be reacted as they are or, if necessary, reacted in the presence of a catalyst. Examples of the catalyst include amine compounds such as triethylamine, organic phosphorus compounds such as triphenylphosphine, and the like, and these may be used alone or in combination of two or more. A polymerization inhibitor may be used to inhibit side reactions during the reaction. Examples of the polymerization inhibitor include hydroquinone, hydroquinone monomethylether, and methylhydroquinone, and these may be used alone or in combination of two or more.

The polyimide resin according to the present embodiment has a light transmittance at wavelengths of from 200 to 400 nm of preferably 50% or greater, more preferably 55% or greater, further preferably 60% or greater, and even further preferably 70% or greater.

The modified polyimide resin (A) according to the present embodiment has a high light transmittance at the above-described wavelengths and excellent solubility in the organic solvent. Therefore, the photopolymerization initiator that can be contained in the composition effectively acts, and thus a cured film can be efficiently formed. In addition, since the modified polyimide resin (A) is used, when a cured film is formed from the composition, it has a low residual film rate of the unexposed portion and excellent developability, and occurrence of cracking and the like can be effectively suppressed.

(Organic Solvent)

The organic solvent is desirably an aprotic polar solvent from the perspective of solubility. Specific examples of the organic solvent can include N-methyl-2-pyrrolidone, N-acetyl-2-pyrrolidone, N-benzyl-2-pyrrolidone, N,N-dimethylformamide, N,N-dimethylacetamide, dimethyl sulfoxide, hexamethylphosphortriamide, N-acetyl-ε-caprolactam, dimethylimidazolidinone, diethylene glycol dimethyl ether, triethylene glycol dimethyl ether, and γ-butyrolactone. These organic solvents may be used alone or in combination of two or more. To further improve the applicability, solvents such as toluene, xylene, diethyl ketone, methoxybenzene, and cyclopentanone may be mixed in a range that does not adversely affect the solubility of the polymer.

The use of an appropriate organic solvent facilitates use of the photosensitive polyimide resin composition according to the present embodiment in a solution (varnish) state, which makes it convenient for film formation.

(Photopolymerizable Compound)

As the photopolymerizable compound, a polyfunctional radically polymerizable monomer, for example, a di- or higher functional (meth)acrylic monomer can be used.

Examples of the (meth)acrylic monomer include tricyclodecanedimethanol di(meth)acrylate, polypropylene glycol di(meth)acrylate, trimethylolpropane tri(meth)acrylate, ethoxylated trimethylolpropane tri(meth)acrylate, propoxylated trimethylolpropane tri(meth)acrylate, pentaerythritol tetra(meth)acrylate, pentaerythritol tri(meth)acrylate, tris-(2-(meth)acryloxyethyl)isocyanurate, ditrimethylolpropane tetra(meth)acrylate, dipentaerythritol penta(meth)acrylate, dipentaerythritol hexa(meth)acrylate, tripentaerythritol (meth)acrylate, mono- and di-pentaerythritol (meth)acrylates, polypentaerythritol (meth)acrylate, polyglycerin-based (meth)acrylate, and dendrimer (meth)acrylate. These photopolymerizable compounds may be used alone or in combination of two or more.

Here, the polyglycerin-based (meth)acrylate refers to a compound having a polyglycerin skeleton and a (meth)acryloyl group. Examples of the polyglycerin-based (meth)acrylate include SA-TE6 and SA-TE60 available from Sakamoto Yakuhin Kogyo Co., Ltd.

As the ethoxylated trimethylolpropane tri(meth)acrylate, for example, ethoxylated (3) trimethylolpropane triacrylate, ethoxylated (6) trimethylolpropane triacrylate, ethoxylated (15) trimethylolpropane triacrylate, or the like available from Arkema K.K. can be used.

The dendrimer (meth)acrylate refers to a polyfunctional (meth)acrylate having a dendrimer structure (including a hyperbranched structure). Examples of the dendrimer (meth)acrylate include Viscoat 1000, Viscoat 1020, and STAR-501 available from Osaka Organic Chemical Industry Ltd. Viscoat 1000 and Viscoat 1020 contain a dendrimer-type polyester acrylate having an acrylate group at a terminal end as a main component. A molecular weight of Viscoat 1000 is about from 1000 to 2000, and a molecular weight of Viscoat 1020 is about from 1000 to 3000. STAR-501 contains, as a main component, a dipentaerythritol hexaacrylate-linked hyperbranched polyacrylate containing a core derived from dipentaerythritol and having an acrylate group at a terminal end. A molecular weight of STAR501 is about from 16000 to 24000.

Among these, as the photopolymerizable compound, a polyfunctional (meth)acrylate having four or more (meth)acryloyl groups in the molecule is preferable, and a polyfunctional (meth)acrylate having four or more and ten or less (meth)acryloyl groups in the molecule is more preferable, from the perspective of suppressing the occurrence of

cracking in the exposed portion after development.

The flexibility and the like of the photosensitive polyimide resin composition can be controlled by the structure of the photopolymerizable compound to be mixed. These photopolymerizable compounds are preferably mixed at a ratio of from 5 to 500 parts by mass with respect to 100 parts by mass of the polyimide resin contained in the photosensitive polyimide resin composition.

(Photopolymerization Initiator)

The photopolymerization initiator is not particularly limited, and a known photopolymerization initiator can be used. Examples of the photopolymerization initiator can include 2,2-dimethoxy-1,2-diphenylethan-1-one, 1-hydroxycyclohexylphenyl ketone, 2-hydroxy-2-methyl-1-phenyl-propan-1-one, 1-[4-(2-hydroxyethoxy)-phenyl]-2-hydroxy-2-methyl-1-propan-1-one, 2-hydroxy-1-{4-[4-(2-hydroxy-2-methyl-propionyl)-benzyl] phenyl}-2-methyl-propan-1-one, 2-methyl-1-(4-methylthiophenyl)-2-morpholinopropan-1-one, 2-benzyl-2-dimethylamino-1-(4-morpholinophenyl)-butanone-1,2-(dimethylamino)-2-[(4-methylphenyl)methyl]-1-[4-(4-morpholinyl)phenyl]-1-butanone, 2,4,6-trimethylbenzoyldiphenylphosphine oxide, and bis(2,4,6-trimethylbenzoyl)phenylphosphine oxide. The photopolymerization initiator may be used alone or in combination of two or more.

The photopolymerization initiator is preferably mixed at a ratio of from 0.1 to 10 parts by mass with respect to 100 parts by mass of the polyimide resin contained in the photosensitive polyimide resin composition.

(Sensitizer)

The sensitizer is not particularly limited, and a known sensitizer can be used. Examples of the sensitizer can include an amino group-containing sensitizer, and preferably a compound having an amino group and a phenyl group in the same molecule. More specifically, examples thereof include benzophenone-based compounds such as 4,4'-dimethylaminobenzophenone, 4,4'-diethylaminobenzophenone, 2-aminobenzophenone, 4-aminobenzophenone, 4,4'-diaminobenzophenone, 3,3'-diaminobenzophenone, 3,4-diaminobenzophenone; p-dialkylaminophenyl group-containing compounds such as 2-(p-dimethylaminophenyl)benzoxazole, 2-(p-diethylaminophenyl)benzoxazole, 2-(p-dimethylaminophenyl)benzo[4,5]benzoxazole, 2-(p-dimethylaminophenyl)benzo[6,7]benzoxazole, 2,5-bis(p-diethylaminophenyl)-1,3,4-oxadiazole, 2-(p-dimethylaminophenyl)benzothiazole, 2-(p-diethylaminophenyl)benzothiazole, 2-(p-dimethylaminophenyl)benzimidazole, 2-(p-diethylaminophenyl)benzimidazole, 2,5-bis(p-diethylaminophenyl)-1,3,4-thiadiazole, (p-dimethylaminophenyl)pyridine, (p-diethylaminophenyl)pyridine, (p-dimethylaminophenyl)quinoline, (p-diethylaminophenyl)quinoline, (p-dimethylaminophenyl)pyrimidine, and (p-diethylaminophenyl)pyrimidine. These sensitizers may be used alone or in combination of two or more.

The sensitizer is preferably mixed at a ratio of from 0.001 to 10 parts by mass with respect to 100 parts by mass of the polyimide resin contained in the photosensitive polyimide resin composition.

(Leveling Agent)

The leveling agent is not particularly limited, and a known leveling agent can be used. Examples of usable leveling agents include various surface conditioners such as a silicon-based surface conditioner, an acrylic surface conditioner, a fluorine-based surface conditioner, a nonionic surface conditioner, a cationic surface conditioner, and an anionic surface conditioner. These surface conditioners may be used alone, or in combination of two or more.

The leveling agent is preferably mixed at a ratio of from 0.001 to 20 parts by mass with respect to 100 parts by mass of the polyimide resin contained in the photosensitive polyimide resin composition.

(Adhesion Improver)

The adhesion improver is not particularly limited, and a known adhesion improver may be used. Examples of usable adhesion improvers include known coupling agents such as a silane coupling agent, a titanate coupling agent and an aluminate coupling agent. Examples of the silane coupling agents include an amino group-containing silane coupling agent, an epoxy group-containing silane coupling agent, a mercapto group-containing silane coupling agent, and a (meth)acrylic group-containing silane coupling agent. Examples of the coupling agents include KP-390, KA-1003, KBM-1003, KBE-1003, KBM-303, KBM-403, KBE-402, KBE-403, KBM-1403, KBM-502, KBM-503, KBE-502, KBE-503, KBM-5103, KBM-602, KBM-603, KBE-603, KBM-903, KBE-903, KBE-9103, KBM-9103, KBM-573, KBM-575, KBM-6123, KBE-585, KBM-703, KBM-802, KBM-803, KBE-846, and KBE-9007 (all trade names; available from Shin-Etsu Chemical Co., Ltd.). These coupling agents may be used alone or in combination of two or more.

The adhesion improver is preferably mixed at a ratio of from 0.0005 to 20 parts by mass with respect to 100 parts by mass of the polyimide resin contained in the photosensitive polyimide resin composition.

(Method for Producing Photosensitive Polyimide Resin Composition)

The photosensitive polyimide resin composition according to the present embodiment is not particularly limited, and can be prepared as follows.
The photosensitive polyimide composition can be produced by mixing the polyimide resin with at least one selected from the group consisting of an organic solvent, a photopolymerization initiator and a photopolymerizable compound. If necessary, as described above, at least one selected from the group consisting of a sensitizer, a leveling agent, and an adhesion improver may be further mixed.

(Polyimide Varnish)

The polyimide varnish according to the present embodiment contains a polyimide resin and an organic solvent, and may further contain at least one selected from the group consisting of a photopolymerization initiator and a photopolymerizable compound. Furthermore, as described above, at least one selected from the group consisting of a sensitizer, a leveling agent, and an adhesion improver may be further mixed as necessary. Specific examples of each component are as described above.
The polyimide varnish according to the present embodiment may be a polyimide solution itself in which a polyimide resin produced by a polymerization method is dissolved in a reaction solvent, or may be a solution produced by further adding an organic solvent to the polyimide solution and diluting the solution.
Since the polyimide resin having an amino group at a terminal end or the modified polyimide resin (A) according to the present embodiment have excellent solvent solubility, it is possible to produce a high-concentration varnish that is stable at room temperature.
The polyimide varnish according to the present embodiment contains the polyimide resin described in detail in an amount of preferably from 5 to 40 mass% and more preferably from 10 to 30 mass%.
A viscosity of polyimide varnish is preferably from 1 to 200 Pa·s, and more preferably from 1 to 100 Pa s. The viscosity of the polyimide varnish is a value as measured at 25°C using an E-type viscometer.
A method for producing the polyimide varnish is not particularly limited, and a known method can be applied.

[Step (b)]

Next, the film formed in step (a) is exposed.
The exposure of the film can be carried out, for example, by irradiating a film composed of the photosensitive polyimide resin composition formed on the substrate with light (usually, ultraviolet rays are used) through a photomask having a predetermined pattern.
The exposed film has a portion where light is blocked by the photomask and a portion irradiated with light, that is, an exposed portion and an unexposed portion.
In the exposed portion of the exposed film, the polyimide resin in the photosensitive polyimide resin composition is cross-linked, a cross-linked polyimide film is formed, and a pattern is formed by the subsequent development step (step (c)). On the other hand, in the unexposed portion, the polyimide resin is not crosslinked, and thus it forms an uncrosslinked polyimide film which is dissolved and removed by development.
An ultraviolet ray irradiation amount is preferably from 100 to 8000 $mJ/cm^2$, and more preferably from 200 to 6000 $mJ/cm^2$ in terms of integrated irradiation amount.

[Step (c)]

Next, the exposed film is developed using a developer to form a pattern formed of the film on the substrate.
For example, a desired relief pattern can be produced by irradiating the film composed of the photosensitive polyimide resin composition formed on the substrate with light, and then dissolving and removing an unexposed portion with a developer.
Step (c) preferably includes step (c 1) of measuring a Hansen solubility parameter of the film before exposure, and step (c2) of selecting a developer having a relative energy difference (RED) from the film before exposure of 0.50 or greater and 1.4 or less using the measured Hansen solubility parameter.
The RED is 0.50 or greater, preferably 0.52 or greater, more preferably 0.55 or greater, and further preferably 0.60 or greater, from the perspective of suppressing occurrence of cracking in the exposed portion after development, and 1.4 or less, preferably 1.3 or less, more preferably 1.2 or less, and further preferably 1.1 or less, from the perspective of suppressing generation of a residue in the unexposed portion after development.
In the method for producing a patterned substrate according to the present embodiment, an organic solvent is preferably used as the developer. The developer dissolves the photosensitive polyimide resin composition according to

the present embodiment, and is not particularly limited as long as the relative energy difference (RED) from the film before exposure falls within the above range. Specific suitable examples of the developer include N-methyl-2-pyrrolidone, N-acetyl-2-pyrrolidone, N-benzyl-2-pyrrolidone, N,N-dimethylformamide, N,N-dimethylacetamide, dimethyl sulfoxide, hexamethylphosphortriamide, N-acetyl-ε-caprolactam, dimethylimidazolidinone, diethylene glycol dimethyl ether, triethylene glycol dimethyl ether, γ-butyrolactone, acetone, methyl ethyl ketone, cyclopentanone, ethyl lactate, propylene glycol monomethyl ether acetate, propylene glycol monomethyl ether, cyclohexanone, ethyl acetate, tetrahydrofuran, acetonitrile, methyl isobutyl ketone, butyl acetate, and 1,4-dioxane. These developers may be used alone or in combination of two or more.

The relief pattern formed by the development is then washed with a rinse solution to remove a developing solvent. Suitable examples of the rinse solution include methanol, ethanol, isopropyl alcohol, and water, which are miscible with the developer.

[Step (d)]

The method for producing a patterned substrate according to the present embodiment may further include step (d) of heat-treating the pattern after step (c).

Thus, a cured film (pattern) formed by curing the photosensitive polyimide resin composition of the present embodiment can be produced.

The relief pattern formed by the process described above can be heat-treated at a temperature selected from a range from 80 to 400°C, the organic solvent is removed, and a cured film (pattern) formed by curing the photosensitive polyimide resin composition of the present embodiment can be produced.

According to the present embodiment, a resin composition which has excellent developability is used, that is, an exposed portion is sufficiently cured, and an unexposed portion is sufficiently removed due to high organic solvent solubility of the modified polyimide resin contained in the photosensitive polyimide resin composition, and thus a relief pattern can be formed with high resolution.

In the method for producing a patterned substrate according to the present embodiment, a thickness of the pattern after the heat treatment, that is, a thickness of the cured film formed by curing the photosensitive polyimide resin composition of the present embodiment is preferably 5 μm or greater and 85 μm or less.

When the film thickness is within the range described above, it can be used as an excellent insulating film. When the film thickness is larger (i.e., the amount of the photosensitive polyimide resin composition applied onto the substrate increases), the solubility of the polyimide resin in the organic solvent often becomes particularly problematic. However, according to the present invention, the modified polyimide resin (A) is used, and thus excellent solubility in the organic solvent and transparency can be both achieved also in such a case.

Therefore, the cured film of the present embodiment can be suitably used in, for example, an insulating film application where the application of high voltage is assumed. The cured film formed from the photosensitive polyimide resin composition of the present embodiment containing the modified polyimide resin (A) can effectively suppress occurrence of cracking and the like, and is excellent in physical properties.

[Application]

The patterned substrate according to the present embodiment can be used in various applications. For example, the patterned substrate can be suitably used in surface protective films and interlayer insulating films of semiconductor elements of electronic devices, wiring protective insulating films of circuit boards, particularly in the above-described applications with high density and high integration. In this case, the pattern of the patterned substrate serves as a surface protective film or an interlayer insulating film of a semiconductor element of an electronic device or a wiring protective insulating film of a circuit board.

Examples

The present invention will be described in further detail hereinafter using examples and comparative examples, but the present invention is not limited to the following examples.

Synthesis Example 1

Into a 1 L five-necked flask equipped with a nitrogen introducing tube, a stirrer, a thermometer, and a condenser, 196.1581 g (0.583 mol) of 4,4'-oxybis[3-(trifluoromethyl)benzenamine] (hereinafter, 6FODA), 124.1578 g (0.554 mol) of 1,2,4,5-cyclohexanetetracarboxylic dianhydride (hereinafter, HPMDA), and 391.50 g of γ-butyrolactone (hereinafter, GBL) were placed under nitrogen, and heated to 90°C with stirring. 2.802 g (0.028 mol) of Triethylamine (hereinafter,

TEA) were added to this mixture, and they were reacted at 190°C for 5 hours, followed by dilution with 308.10 g of GBL to produce 999 g of polyimide varnish (total of distilled water and distilled TEA: 23.7 g) having a solid content concentration of 30 mass%. As a result of measurement by GPC, the weight average molecular weight (Mw) of the resulting polyimide in this synthesis example was 33876.

Into 200.03 g of this polyimide varnish, 100.01 g of GBL and 6.0264 g of 2-isocyanatoethyl acrylate (Karenz AOI, available from Showa Denko K.K.) were put, and they were reacted for 5 hours at 50°C. Thereafter, the reaction liquid was dropped into water, and the polyimide was deposited, dried overnight at 70°C, and a modified polyimide resin (A1) was produced.

The evaluation methods employed in the examples and comparative examples are as follows.

(1) Weight Average Molecular Weight (Mw)

Mw was determined by GPC analysis. The equipment used for the analysis and the analysis conditions were as follows.

Apparatus: HLC-8420GPC (available from Tosoh Corporation)
Column: TSKgel SuperAWM-H×2 (available from Tosoh Corporation)
Eluent: (30 mM Lithium bromide and 100 mM phosphoric acid) added dimethylformamide
Standard polystyrene: PStQuick Kit-H (available from Tosoh Corporation)
Flow rate: 0.6 mL/min
Column temperature: 40°C
Detector: RI (refractive index detector)

(2) Calculation 1 of Hansen Solubility Parameter (HSP) of Photosensitive Polyimide Resin Composition

2.8586 g of the modified polyimide resin (A1) produced in Synthesis Example 1 was dissolved in 3.5269 g of GBL. To this solution, added were: 1.4596 g of Viscoat 802 (TriPEA, available from Osaka Organic Chemical Industry Ltd.) as a photopolymerizable compound, 0.0431 g of 1-hydroxycyclohexyl phenyl ketone (Omnirad 184, available from BASF) and 0.1005 g of bis(2,4,6-trimethylbenzoyl)phenylphosphine oxide (Omnirad 819, available from BASF) as photopolymerization initiators, 0.2876 g of LE-304 (available from Kyoeisha Chemical Co., Ltd.) diluted 100 times with GBL as a leveling agent, and 0.1496 g of KP-390 (available from Shin-Etsu Chemical Co., Ltd.) diluted 100 times with GBL as an adhesion improver, followed by stirring until these materials were sufficiently dissolved, to produce a photosensitive polyimide resin composition (polyimide varnish). The polyimide varnish was cast on a PET film using a glass rod and a spacer having a thickness of 300 μm, and dried at 100°C for 60 minutes to form a film of the photosensitive polyimide resin composition.

The films were cut into an appropriate size, and completely immersed, one by one, in solvents having known HSPs (the HSPs are registered in the HSPiP database), i.e., acetone, N,N-dimethylacetamide (hereinafter, DMAc), methyl ethyl ketone (hereinafter, MEK), diacetone alcohol, N-methyl-2-pyrrolidone (hereinafter, NMP), N,N-dimethylformamide (hereinafter, DMF), dichloromethane, cyclopentanone, ε-caprolactone, ethyl lactate (hereinafter, EL), propylene glycol monomethyl ether acetate (hereinafter, PGMEA), propylene glycol monomethyl ether (hereinafter, PGME), cyclohexanone, ethyl acetate, tetrahydrofuran, acetonitrile, GBL, methyl isobutyl ketone (hereinafter, MIBK), dimethyl sulfoxide, butyl acetate, butyl benzoate, benzyl alcohol, 2-phenoxyethanol, 1-butanol, 1,1,2,2-tetrachloroethane, dipropylene glycol, cyclohexanol, chloroform, ethanol, toluene, methanol, hexane, cyclohexane, water, 1,4-dioxane, and diethylene glycol, and allowed to stand at room temperature for 4 days. Thereafter, whether the film was soluble or insoluble in each solvent was visually determined. When the HSP (δd: dispersion term, δp: polar term, δh: hydrogen-bond term) and $R_0$: interaction radius were calculated using the above-described Hansen sphere method, δd: 15.54 $MPa^{1/2}$, δp: 11.73 $MPa^{1/2}$, δh: 8.20 $MPa^{1/2}$, and $R_0$ = 9.7 $MPa^{1/2}$. The Fit value, which is the ratio of the good solvent entering the Hansen sphere, was 0.882.

(2) Calculation 2 of Hansen Solubility Parameter (HSP) of Photosensitive Polyimide Resin Composition

2.3883 g of the modified polyimide resin (A1) produced in Synthesis Example 1 was dissolved in 2.9267 g of GBL. To this solution, added were: 1.2033 g of diPE-penta/hexa-A (available from Shin-Nakamura Chemical Co., Ltd) as a photopolymerizable compound, 0.0346 g of 1-hydroxycyclohexyl phenyl ketone (Omnirad 184, available from BASF) and 0.0820 g of bis(2,4,6-trimethylbenzoyl)phenylphosphine oxide (Omnirad 819, available from BASF) as photopolymerization initiators, 0.2550 g of LE-304 (available from Kyoeisha Chemical Co., Ltd.) diluted 100 times with GBL as a leveling agent, and 0.1211 g of KP-390 (available from Shin-Etsu Chemical Co., Ltd.) diluted 100 times with GBL as an adhesion improver, followed by stirring until these materials were sufficiently dissolved, to produce a photosensitive

polyimide resin composition (polyimide varnish). The polyimide varnish was cast on a PET film using a glass rod and a spacer having a thickness of 300 μm, and dried at 100°C for 60 minutes to form a film of the photosensitive polyimide resin composition.

The films were cut into an appropriate size, and completely immersed, one by one, in solvents having known HSPs (the HSPs are registered in the HSPiP database), i.e., acetone, N,N-dimethylacetamide (hereinafter, DMAc), methyl ethyl ketone (hereinafter, MEK), diacetone alcohol, N-methyl-2-pyrrolidone (hereinafter, NMP), N,N-dimethylformamide (hereinafter, DMF), dichloromethane, cyclopentanone, ε-caprolactone, ethyl lactate (hereinafter, EL), propylene glycol monomethyl ether acetate (hereinafter, PGMEA), propylene glycol monomethyl ether (hereinafter, PGME), cyclohexanone, ethyl acetate, tetrahydrofuran, acetonitrile, GBL, methyl isobutyl ketone (hereinafter, MIBK), dimethyl sulfoxide, butyl acetate, butyl benzoate, benzyl alcohol, 2-phenoxyethanol, 1-butanol, 1,1,2,2-tetrachloroethane, dipropylene glycol, cyclohexanol, chloroform, ethanol, toluene, methanol, hexane, cyclohexane, water, 1,4-dioxane, and diethylene glycol, and allowed to stand at room temperature for 4 days. Thereafter, whether the film was soluble or insoluble in each solvent was visually determined. When the HSP (δd: dispersion term, δp: polar term, δh: hydrogen-bond term) and $R_0$: interaction radius were calculated using the above-described Hansen sphere method, δd: 15.54 $MPa^{1/2}$, δp: 11.73 $MPa^{1/2}$, δh: 8.20 $MPa^{1/2}$, and $R_0$ = 9.7 $MPa^{1/2}$. The Fit value, which is the ratio of the good solvent entering the Hansen sphere, was 0.879.

Example 1

As shown in Table 1, a polyimide varnish was prepared by blending the materials at the same ratio as in the above HSP calculation 1. This polyimide varnish was applied onto a silicon wafer using a spin coater (MS-B150) available from Mikasa Co., Ltd. under conditions such that the thickness of the polyimide coating film after drying was from 25 to 30 μm, and dried at 100°C for 5 minutes. After cooling to room temperature, the polyimide coating film was exposed from above a photomask having an L/S (line & space) pattern of 30 μm/50 μm using a mask aligner (MA-10) available from MIKASA Co., Ltd. and a high-pressure mercury lamp as a light source under the condition: an exposure amount of 5000 $mJ/cm^2$ at an exposure wavelength of 365 nm, and allowed to stand at room temperature for 15 minutes. Then, the film was subjected to immersion development for 90 seconds using ethyl lactate (EL) as a developer, and rinsed with methanol, and the residual solvent was removed under air flow to form a resin pattern of 30 μm/50 μm on the silicon wafer.

Then, the developability of the pattern and the presence or absence of cracking in the exposed portion were observed and evaluated using a digital microscope.

Table 1

| Blending composition of polyimide varnish (unit: g) | |
|---|---|
| Modified polyimide resin (A1) | 2.5053 |
| GBL | 3.0642 |
| Viscoat 802 | 1.2731 |
| Omnirad 184 | 0.0372 |
| Omnirad 819 | 0.0865 |
| LE-304 (GBL 100-fold diluted product) | 0.2723 |
| KP-390 (GBL 100-fold diluted product) | 0.1272 |

Example 2

A polyimide varnish was prepared in the same manner as in Example 1 except that propylene glycol monomethyl ether acetate (PGMEA) was used as the developer, and was evaluated in the same manner as in Example 1.

Example 3

A polyimide varnish was prepared in the same manner as in Example 1 except that propylene glycol monomethyl ether (PGME) was used as the developer, and was evaluated in the same manner as in Example 1.

Example 4

A polyimide varnish was prepared in the same manner as in Example 1 except that cyclohexanone was used as the developer, and was evaluated in the same manner as in Example 1.

Example 5

A polyimide varnish was prepared in the same manner as in Example 1 except that acetonitrile was used as the developer, and was evaluated in the same manner as in Example 1.

Example 6

A polyimide varnish was prepared in the same manner as in Example 1 except that methyl isobutyl ketone (MIBK) was used as the developer, and was evaluated in the same manner as in Example 1.

Example 7

A polyimide varnish was prepared in the same manner as in Example 1 except that a mixed solvent of 1,4-dioxane and ε-caprolactone in a volume ratio of 53:47 was used as the developer, and was evaluated in the same manner as in Example 1.

Example 8

A polyimide varnish was prepared in the same manner as in Example 1 except that a mixed solvent of ε-caprolactone, toluene, and benzyl alcohol in a volume ratio of 35:35:30 was used as the developer, and was evaluated in the same manner as in Example 1.

Example 9

A polyimide varnish was prepared in the same manner as in Example 1 except that butyl acetate was used as the developer, and was evaluated in the same manner as in Example 1.

Example 10

A polyimide varnish was prepared in the same manner as in Example 1 except that 1,4-dioxane was used as the developer, and was evaluated in the same manner as in Example 1.

Comparative Example 1

A polyimide varnish was prepared in the same manner as in Example 1 except that acetone was used as the developer, and was evaluated in the same manner as in Example 1.

Comparative Example 2

A polyimide varnish was prepared in the same manner as in Example 1 except that N,N-dimethylacetamide (DMAc) was used as the developer, and was evaluated in the same manner as in Example 1.

Comparative Example 3

A polyimide varnish was prepared in the same manner as in Example 1 except that methyl ethyl ketone (MEK) was used as the developer, and was evaluated in the same manner as in Example 1.

Comparative Example 4

A polyimide varnish was prepared in the same manner as in Example 1 except that cyclohexane was used as the developer, and was evaluated in the same manner as in Example 1.
The results of Examples 1 to 10 and Comparative Examples 1 to 4 are shown in Table 2.

Table 2

| | Developer | δd | δp | δh | RED | L/S = 30/50 Developability | Cracking |
|---|---|---|---|---|---|---|---|
| Example 1 | EL | 16.0 | 7.6 | 12.5 | 0.62 | Good | Absent |
| Example 2 | PGMEA | 15.6 | 5.6 | 9.8 | 0.65 | Good | Absent |
| Example 3 | PGME | 15.6 | 6.3 | 11.6 | 0.66 | Good | Absent |
| Example 4 | Cyclohexanone | 17.8 | 8.4 | 5.1 | 0.66 | Good | Absent |
| Example 5 | Acetonitrile | 15.3 | 18.0 | 6.1 | 0.68 | Good | Absent |
| Example 6 | MIBK | 15.3 | 6.1 | 4.1 | 0.72 | Good | Absent |
| Example 7 | 1,4-Dioxane: caprolactone = 53:47 | 18.5 | 8.0 | 8.2 | 0.72 | Good | Absent |
| Example 8 | Caprolactone: toluene:benzyl alcohol = 35:35:30 | 18.7 | 7.6 | 7.4 | 0.78 | Good | Absent |
| Example 9 | Butyl acetate | 15.8 | 3.7 | 6.3 | 0.85 | Good | Absent |
| Example 10 | 1,4-Dioxane | 17.5 | 1.8 | 9.0 | 1.1 | Good | Absent |
| Comparative Example 1 | Acetone | 15.5 | 10.4 | 7.0 | 0.19 | Good | Present |
| Comparative Example 2 | DMAc | 16.8 | 11.5 | 9.4 | 0.29 | Good | Present |
| Comparative Example 3 | MEK | 16.0 | 9.0 | 5.1 | 0.44 | Good | Present |
| Comparative Example 4 | Cyclohexane | 16.8 | 0.0 | 0.2 | 1.5 | Poor | Absent |
| Good: No residue in unexposed portion<br>Poor: Residue in unexposed portion | | | | | | | |

Example 11

As shown in Table 3, a polyimide varnish was prepared by blending the materials at the same ratio as in the above HSP calculation 2. This polyimide varnish was applied onto a silicon wafer using a spin coater (MS-B 150) available from Mikasa Co., Ltd. under conditions such that the thickness of the polyimide coating film after drying was from 25 to 30 μm, and dried at 100°C for 5 minutes. After cooling to room temperature, the polyimide coating film was exposed from above a photomask having an L/S (line & space) pattern of 30 μm/50 μm using a mask aligner (MA-10) available from MIKASA Co., Ltd. and a high-pressure mercury lamp as a light source under the condition: an exposure amount of 5000 $mJ/cm^2$ at an exposure wavelength of 365 nm, and allowed to stand at room temperature for 15 minutes. Then, the film was subjected to immersion development for 90 seconds using N-methyl-2-pyrrolidone (NMP) as a developer, and rinsed with methanol, and the residual solvent was removed under air flow to form a resin pattern of 30 μm/50 μm on the silicon wafer.

Then, the developability of the pattern and the presence or absence of cracking in the exposed portion were observed and evaluated using a digital microscope.

Table 3

| Blending composition of polyimide varnish (unit: g) | |
|---|---|
| Modified polyimide resin (A1) | 9.1424 |
| GBL | 11.1723 |
| diPE-penta/hexa-A | 4.5847 |
| Omnirad 184 | 0.1385 |

(continued)

| Blending composition of polyimide varnish (unit: g) | |
|---|---|
| Omnirad 819 | 0.3201 |
| LE-304 (GBL 100-fold diluted product) | 0.9401 |
| KP-390 (GBL 100-fold diluted product) | 0.6700 |

Example 12

A polyimide varnish was prepared in the same manner as in Example 11 except that cyclopentanone was used as the developer, and was evaluated in the same manner as in Example 11.

Example 13

A polyimide varnish was prepared in the same manner as in Example 11 except that EL was used as the developer, and was evaluated in the same manner as in Example 11.

Example 14

A polyimide varnish was prepared in the same manner as in Example 11 except that PGMEA was used as the developer, and was evaluated in the same manner as in Example 11.

Example 15

A polyimide varnish was prepared in the same manner as in Example 11 except that cyclohexanone was used as the developer, and was evaluated in the same manner as in Example 11.

Example 16

A polyimide varnish was prepared in the same manner as in Example 11 except that a mixed solvent of 1,4-dioxane and ε-caprolactone in a volume ratio of 53:47 was used as the developer, and was evaluated in the same manner as in Example 11.

Example 17

A polyimide varnish was prepared in the same manner as in Example 11 except that a mixed solvent of ε-caprolactone, toluene, and benzyl alcohol in a volume ratio of 35:35:30 was used as the developer, and was evaluated in the same manner as in Example 11.

Example 18

A polyimide varnish was prepared in the same manner as in Example 11 except that butyl acetate was used as the developer, and was evaluated in the same manner as in Example 11.

Example 19

A polyimide varnish was prepared in the same manner as in Example 11 except that 1,4-dioxane was used as the developer, and was evaluated in the same manner as in Example 11.

Comparative Example 5

A polyimide varnish was prepared in the same manner as in Example 11 except that acetone was used as the developer, and was evaluated in the same manner as in Example 11.

Comparative Example 6

A polyimide varnish was prepared in the same manner as in Example 11 except that DMAc was used as the developer, and was evaluated in the same manner as in Example 11.

Comparative Example 7

A polyimide varnish was prepared in the same manner as in Example 11 except that cyclohexane was used as the developer, and was evaluated in the same manner as in Example 11.

The results of Examples 11 to 19 and Comparative Examples 5 to 7 are shown in Table 4.

Table 4

| | Developer | δd | δp | δh | RED | L/S = 30/50 Developability | Cracking |
|---|---|---|---|---|---|---|---|
| Example 11 | NMP | 18.0 | 12.3 | 7.2 | 0.52 | Good | Absent |
| Example 12 | Cyclopentanone | 17.9 | 11.9 | 5.2 | 0.58 | Good | Absent |
| Example 13 | EL | 16.0 | 7.6 | 12.5 | 0.62 | Good | Absent |
| Example 14 | PGMEA | 15.6 | 5.6 | 9.8 | 0.65 | Good | Absent |
| Example 15 | Cyclohexanone | 17.8 | 8.4 | 5.1 | 0.66 | Good | Absent |
| Example 16 | 1,4-Dioxane:caprolactone = 53:47 | 18.5 | 8.0 | 8.2 | 0.72 | Good | Absent |
| Example 17 | Caprolactone:toluene: benzyl alcohol = 35:35:30 | 18.7 | 7.6 | 7.4 | 0.78 | Good | Absent |
| Example 18 | Butyl acetate | 15.8 | 3.7 | 6.3 | 0.85 | Good | Absent |
| Example 19 | 1,4-Dioxane | 17.5 | 1.8 | 9.0 | 1.1 | Good | Absent |
| Comparative Example 5 | Acetone | 15.5 | 10.4 | 7.0 | 0.19 | Good | Present |
| Comparative Example 6 | DMAc | 16.8 | 11.5 | 9.4 | 0.29 | Good | Present |
| Comparative Example 7 | Cyclohexane | 16.8 | 0.0 | 0.2 | 1.5 | Poor | Absent |
| Good: No residue in unexposed portion<br>Poor: Residue in unexposed portion | | | | | | | |

## Claims

1. A method for producing a patterned substrate, comprising:

    step (a) of forming a film composed of a photosensitive polyimide resin composition on a substrate;
    step (b) of exposing the film; and
    step (c) of developing the exposed film using a developer to form a pattern formed of the film on the substrate, wherein a relative energy difference (RED) between the developer and the film before exposure is 0.50 or greater and 1.4 or less.

2. The method for producing a patterned substrate according to claim 1, wherein the step (c) comprises step (c1) of measuring a Hansen solubility parameter of the film before exposure, and step (c2) of selecting a developer having a relative energy difference (RED) from the film before exposure of 0.50 or greater and 1.4 or less using the measured Hansen solubility parameter.

3. The method for producing a patterned substrate according to claim 1 or 2, wherein the step (a) comprises step (a1)

of applying a varnish-state photosensitive polyimide resin composition onto the substrate, and step (a2) of removing an organic solvent from the applied varnish-state photosensitive polyimide resin composition.

4. The method for producing a patterned substrate according to any one of claims 1 to 3, further comprising step (d) of heat-treating the pattern after the step (c).

5. The method for producing a patterned substrate according to claim 4, wherein a thickness of the pattern after the heat treatment is 5 μm or greater and 85 μm or less.

6. The method for producing a patterned substrate according to any one of claims 1 to 5, wherein a polyimide resin contained in the photosensitive polyimide resin composition comprises a modified polyimide resin (A) having a repeating structure represented by General Formula (1):

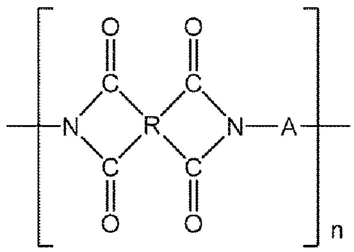

(1)

where R is a tetravalent group with from 4 to 25 carbons, having a cyclic structure, an acyclic structure, or a cyclic structure and an acyclic structure; A has at least one group selected from the group consisting of an aliphatic hydrocarbon group, an alicyclic hydrocarbon group, an aromatic hydrocarbon group, and an organosiloxane group, and is a divalent group with from 2 to 39 carbons; on a main chain of A, at least one intervening group selected from the group consisting of -O-, $-SO_2-$, -CO-, $-CH_2-$, $-C(CH_3)_2-$, $-C_2H_4O-$, and -S- may be present; n represents a number of repeating units; and terminal ends of General Formula (1) are each selected from the group consisting of a group represented by General Formula (2), a group represented by General Formula (3), or a hydrogen atom, and at least one of the terminal ends is a group represented by General Formula (2) or (3):

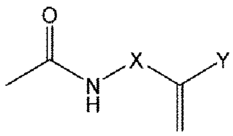

(2)

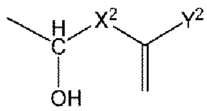

(3)

where X and $X^2$ are each independently a group with from 2 to 15 carbons and may have at least one group selected from the group consisting of ester bonds and double bonds, and Y and $Y^2$ are each independently a hydrogen atom or a methyl group.

7. The method for producing a patterned substrate according to claim 6, wherein A in General Formula (1) comprises at least one selected from the group consisting of an alicyclic hydrocarbon group and an aromatic hydrocarbon group.

8. The method for producing a patterned substrate according to any one of claims 1 to 7, wherein the polyimide resin contained in the photosensitive polyimide resin composition has a weight average molecular weight of 5000 or greater and 70000 or less.

9. The method for producing a patterned substrate according to any one of claims 1 to 8, wherein a light transmittance at a wavelength of from 200 to 400 nm of the polyimide resin contained in the photosensitive polyimide resin composition is 50% or greater.

10. The method for producing a patterned substrate according to any one of claims 1 to 9, wherein the photosensitive polyimide resin composition further comprises at least one selected from the group consisting of a photopolymerization initiator, an organic solvent, and a photopolymerizable compound.

11. The method for producing a patterned substrate according to claim 10, wherein the photopolymerizable compound comprises a polyfunctional radically polymerizable monomer.

12. The method for producing a patterned substrate according to claim 10 or 11, wherein the photopolymerizable compound comprises a polyfunctional (meth)acrylate having four or more (meth)acryloyl groups in a molecule thereof.

13. The method for producing a patterned substrate according to any one of claims 1 to 12, wherein the photosensitive polyimide resin composition further comprises at least one selected from the group consisting of a sensitizer, a leveling agent, and an adhesion improver.

**INTERNATIONAL SEARCH REPORT**

International application No. **PCT/JP2021/041278**

**A. CLASSIFICATION OF SUBJECT MATTER**

***C08F 290/06***(2006.01)i; ***C08G 73/10***(2006.01)i; ***G03F 7/004***(2006.01)i; ***G03F 7/027***(2006.01)i; ***G03F 7/20***(2006.01)i
FI: G03F7/027 514; G03F7/004 504; C08G73/10; C08F290/06; G03F7/20 501; G03F7/20 521

According to International Patent Classification (IPC) or to both national classification and IPC

**B. FIELDS SEARCHED**

Minimum documentation searched (classification system followed by classification symbols)

C08F290/06; C08G73/10; G03F7/004; G03F7/027; G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2008-292799 A (TORAY IND INC) 04 December 2008 (2008-12-04) claims | 1-13 |
| A | JP 2002-214801 A (TORAY IND INC) 31 July 2002 (2002-07-31) claims | 1-13 |

☐ Further documents are listed in the continuation of Box C.  ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 January 2022** | **01 February 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/041278**

| Patent document cited in search report | Publication date (day/month/year) | Patent family member(s) | Publication date (day/month/year) |
|---|---|---|---|
| JP 2008-292799 A | 04 December 2008 | (Family: none) | |
| JP 2002-214801 A | 31 July 2002 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008292799 A
- JP 2002214801 A
- JP 10123725 A
- JP 2002014476 A
- WO 2018221457 A